# EUROPEAN PATENT APPLICATION

(11) **EP 2 088 213 A1**
(43) Date of publication of application: **12.08.2009**
(21) Application number: 09000150.4
(22) Date of filing: 08.01.2009
(51) Int. Cl.: C21D 1/76, C21D 9/00, C21D 11/00, C22F 1/02

(54) **Method for press hardening of metals**

(30) Priority: 08.01.2008 EP 08000242
(71) Applicant: Linde Aktiengesellschaft, 80331 München (DE)
(72) Inventor: Wiberg, Sören, 17835 Ekerö (SE); Laumen, Christoph, 80634 München (DE)
(74) Representative: Gellner, Bernd

(57) **Abstract**

The invention relates to a method for press hardening of a metal or an alloy wherein said metal is heated in a controlled furnace atmosphere which is essentially hydrogen-free and which comprises mainly nitrogen and further carbon monoxide and an enrichment gas such as propane.

## Description

The invention relates to a method for press hardening of a metal or an alloy wherein said metal or alloy is heated in a furnace and the hot metal or alloy is formed and cooled in a die.

The composition, function and control of the furnace atmosphere are of crucial importance for the result of all heat treatments.

In the following the term annealing is used for heat treatment of metals or alloys which requires a controlled atmosphere, and where the aim is to produce certain microstructures and properties. Annealing is done both in steel and nonferrous milling plants.

In the manufacturing industries annealing furnaces have a wide range of sizes and designs from a small box furnace in a tool room, to a big continuous isothermal annealing furnace in the automotive transmission workshop, from the advanced vacuum furnace in the aerospace industry to air filled furnaces for lower demand industries.

Hardening is a heat treatment procedure for steels with the aim to produce a martensitic or bainitic microstructure. Hardening is normally described separately from annealing but the furnace atmosphere requirements are similar for both processes. Hardening involves the steps of heating up to a temperature above the temperature, where the steel is austenitic, followed by a fast quench. The austenite will transform upon quenching to the hard microstructure martensite or bainite if the quenching rate is fast enough.

The so-called press hardening method, also known as hot stamping or hot forming, is used to produce parts of extremely high strength. The metal or alloy is heated up to a temperature between 800 and 1000 °C, introduced into a die and then subjected to a hot forming process. The term "die" shall mean any kind of die, stamp or press which can be used to change the form of a hot metal object. In the die the metal object is formed hot and then cooled and whereby hardened. The forming step and the cooling and hardening step are carried out within the die. So produced steels show a very high tensile strength.

To avoid the negative effects of oxidation, carburizing, decarburization or nitriding during annealing or hardening, the atmosphere must be controlled with respect to the annealed or hardened alloy. The carbon potential of a furnace atmosphere is equal to the carbon content that pure iron would have in equilibrium with the atmosphere. The carbon activity (aC) of a furnace atmosphere is the carbon content a metal or alloy would have compared to the reference, graphite, defined as being equal to aC=1. Both the carbon activity and the carbon potential in heat treatment processes affect the final properties of the metal/alloy in many ways.

In order to avoid the creation of metal oxides on the surface of the heat treated metal or alloy the heat treatment process is often carried out in a reducing atmosphere. For example a heat treatment atmosphere for annealing of copper wire coils might contain nitrogen with 3% hydrogen.

Besides the described synthetic nitrogen-hydrogen atmosphere, today the atmosphere is often based on a combination of nitrogen and endogas. If the endogas is made from natural gas it may contain up to 40 vol% of hydrogen, some carbon monoxide (ca 20 vol%), carbon dioxide and water (ca 0,3 - 1 vol%) with the remainder being nitrogen.

In neutral annealing and neutral hardening, e.g. in press hardening or hot forming of steel parts, a reducing atmosphere has to be used in order to avoid oxidation of the steel surface. A typical reducing agent is hydrogen. However, especially when a high-strength steel is subjected to a hydrogen containing atmosphere hydrogen embrittlement may occur, that is the steel becomes brittle and might crack.

Thus it is an object of the invention to develop an improved method for press hardening of metals or alloys.

This object is achieved by a method for press hardening of a metal or an alloy wherein said metal or alloy is heated in a furnace and the hot metal or alloy is formed and cooled in a die, which is **characterized in that** nitrogen and carbon monoxide are introduced into said furnace to create a controlled furnace atmosphere and in that no hydrogen is introduced into said furnace.

According to the invention the metal or alloy is heated in a furnace and then the hot metal or alloy is directly transported into the die where it is formed and cooled. In the furnace a controlled atmosphere is used which is essentially free of hydrogen and which comprises nitrogen and carbon monoxide. The concentration of carbon monoxide in nitrogen could be between 0,1 and 99 vol%. The proposed atmosphere has no or only low driving force for de-carburization. The invention provides a neutral atmosphere for heating metals for subsequent press hardening.

The heating process is carried out in a controlled furnace atmosphere which is essentially hydrogen free. "Essentially hydrogen free" means that no hydrogen gas is introduced into the furnace. Depending on the composition of the feed gas to the furnace it is sometimes unavoidable that small amounts of hydrogen are produced in the furnace by reaction of the components of the feed gas with each other. However, according to the invention the feed gas to the furnace does not contain hydrogen gas.

The inventive furnace atmosphere comprises nitrogen and carbon monoxide. Both gases, nitrogen and carbon monoxide, are directly introduced into the furnace rather than being produced in the furnace. That is, the feed gas to the furnace comprises nitrogen and carbon monoxide. By directly feeding nitrogen and carbon monoxide into the furnace the composition of the furnace atmosphere can be better controlled.

Especially in hardening processes the metal or alloy is rapidly cooled, especially by gas cooling, after the heat treatment process. The cooling is preferably achieved by quenching the metal parts by means of a cold protective gas. In press hardening the metal or alloy is heated in the furnace and then directly transported into the die for hot forming. During the hot forming process the metal object is cooled, preferably rapidly cooled, in order to harden the metal object. The cooling rate is preferably chosen to be more than 30°C/sec, more preferred more than 40°C/sec. It has been found that in this way a hard martensitic microstructure is achieved.

The inventive furnace atmosphere is in thermodynamic equilibrium. Thus, it is possible to implement a process control using an external heated oxygen probe or a gas analyser measuring carbon dioxide in combination with measurements of the carbon monoxide level and the process temperature.

The invention is preferably used for press hardening of boron containing steel. Further alloying elements such as chromium, manganese, silicon, nickel, molybdenum, cobalt or tungsten might be present in the steel. Boron containing steels or boron alloyed steels are very sensitive to hydrogen. According to the invention no hydrogen gas is fed into the furnace. Thus the risk of hydrogen embrittlement is avoided or at least minimized. The invention provides a solution for heating up boron containing steels before press forming without dissolving hydrogen in the steel.

The invention provides an atmosphere for neutral annealing and neutral hardening. That means, there are essentially no net reactions between the atmosphere and the metal. The inventive atmosphere is neutral with respect to carburization, that is undesired de-carburization as well as carburization are avoided. Metal oxides, in particular surface metal oxides, are reduced and oxidation is prevented.

In a preferred embodiment a carbon containing enrichment gas is added to the furnace atmosphere. The term "enrichment gas" shall mean a gas which allows to adjust the carbon potential or carbon activity to a pre-set value. Preferred enrichment gases are acetylene, propane and/or methane.

The inventive atmosphere may be advantageously produced by one of the following methods:
- Removal of hydrogen from endogas:
   In order to create the inventive atmosphere hydrogen is removed from the endogas. This is preferably achieved by using adsorption techniques, in particular a PSA process (pressure swing adsorption).
- Removal of hydrogen from syngas:
   Syngas or synthesis gas, is the name given to gases of varying composition that are generated in coal gasification and some types of waste-to-energy gasification facilities. Syngas consists primarily of carbon monoxide and
   hydrogen. By removing the hydrogen from the syngas an inventive atmosphere is created which has a high carbon monoxide concentration.
- Removal of hydrogen from cracked methanol since cracked methanol could be regarded as a syngas with the composition of 33% CO and 67% H₂.
- Production of carbon monoxide with added air over a heated bed of doped graphite:
   Air or impure nitrogen with a quality containing residual oxygen levels up to 3% is used and the contained oxygen is caused to react to carbon monoxide inside the furnace over a graphite or coal bed or in an external coal filled reactor.
- Production of carbon monoxide by dissociating formic acid injected into a heated reactor filled with sulphuric acid or phosphoric acid. The formed carbon monoxide is then dried from water and scrubbed to reach neutral pH-value.

Since the inventive atmosphere is hydrogen free the above mentioned problems with hydrogen embrittlement are avoided. Thus the invention is particularly useful in hardening processes where the parts are not tempered after quenching which could take place in cooled tools, submersion in water, oil polymer, molten salt or in gas. Examples of such processes are hot forming of steel or press hardening of steel. Oxidation of the steel surface is prevented by the inventive addition of carbon monoxide to the atmosphere which has a reducing effect.

### Examples:

The invention provides a solution for a reducing controlled atmosphere for annealing or hardening coated steel, which in hydrogen containing atmosphere could dissolve hydrogen into the steel.

Another example of processes where the invention is used with advantage is in manufacturing of fasteners e.g. screws, bolts, nails, nuts. These products are subjected to a high static load during the lifetime, a condition where atomic dissolved hydrogen could be a potential risk especially when tempering of the martensite is done at low temperature.

Another example relates to bainite hardened steels which are quenched in molten salt or hot gas. The inventive hydrogen free atmosphere could positively affect the austenitising process e.g in the production of bearing steels.

## Claims

1. Method for press hardening of a metal or an alloy wherein said metal or alloy is heated in a furnace and the hot metal or alloy is formed and cooled in a die, **characterized in that** nitrogen and carbon monoxide are introduced into said furnace to create a controlled furnace atmosphere and **in that** no hydrogen is introduced into said furnace.

2. Method according to claim 1 **characterized in that** said furnace atmosphere comprises a carbon containing enrichment gas.

3. Method according to claim 2 **characterized in that** acetylene, propane and/or methane is used as said enrichment gas.

4. Method according to any of claims 1 to 3 **characterized in that** said nitrogen and carbon monoxide which are introduced into said furnace are produced by removal of hydrogen from syngas or from endogas or from cracked methanol.

5. Method according to any of claims 1 to 3 **characterized in that** said nitrogen and carbon monoxide which are introduced into said furnace are produced by reacting a nitrogen containing gas containing less than 10% oxygen, preferably less than 3% oxygen, over graphite.

6. Method according to any of claims 1 to 3 **characterized in that** said carbon monoxide is produced by injecting formic acid into a heated reactor filled with sulphuric acid or phosphoric acid and dissociating said formic acid whereby forming carbon monoxide.

7. Method according to any of claims 1 to 6 **characterized in that** the heating process in said furnace is controlled by means of an heated external oxygen probe or a carbon dioxide gas analyser in combination with measurements of carbon monoxide and furnace temperature.

8. Method according to any of claims 1 to 7 **characterized in that** said furnace atmosphere comprises between 1% and 5% CO, between 90% and 99% N₂ and between 0.05% and 1% hydrocarbon gas.

9. Method according to any of claims 1 to 8 **characterized in that** said metal or alloy is subjected to a hardening process where said metal or alloy is heated up and then quenched but wherein said metal or alloy is not tempered after quenching.

10. Method according to any of claims 1 to 9 **characterized in that** fasteners made of metal or alloy are heated in said furnace atmosphere.
